# EUROPEAN PATENT APPLICATION

(11) **EP 4 761 517 A1**
(43) Date of publication of application: **17.06.2026**
(21) Application number: 24220120.0
(22) Date of filing: 16.12.2024
(51) Int. Cl.: H10F 19/31, C05B 1/04, H10F 19/35, H10F 77/20

(54) **A THIN FILM PHOTOVOLTAIC UNIT, A PHOTOELECTROCHEMICAL MODULE, A METHOD FOR FORMING SUCH A PHOTOVOLTAIC UNIT, A METHOD FOR FORMING SUCH A PHOTOELECTROCHEMICAL MODULE AND USE OF SUCH A MODULE**

(71) Applicant: CTF Solar GmbH, 01099 Dresden (DE)
(72) Inventor: SPÄTH, Bettina, Dresden (DE); SIEPCHEN, Bastian, Dresden (DE)
(74) Representative: Kailuweit & Uhlemann Patentanwälte Partnerschaft mbB

(57) **Abstract**

The present invention relates to a thin film photovoltaic unit (100) and a photoelectrochemical module (200) comprising such a photovoltaic unit. The present invention further relates to methods for forming such a photovoltaic unit and such a photoelectrochemical module and to a use of such a module. The photovoltaic unit comprises a transparent substrate (120), at least two photovoltaic cells (1111, 1112, 1121, 1122), a front contact layer (125), an absorber layer (130) and a back contact layer (135). The photovoltaic unit is divided into a first photovoltaic subunit (111) and a second photovoltaic subunit (112), each of which comprises one or more of the photovoltaic cells that are series connected with each other. In each photovoltaic subunit, the back contact layer (135) comprises a first region (1351) that is electrically connected with the front contact (125) of one of the photovoltaic cells of the respective photovoltaic subunit, and a second region (1352) that serves as a back contact of one of the photovoltaic cells of the respective photovoltaic subunit. The first and the second photovoltaic subunits (111, 112) share a common first region (1351) of the back contact layer. A cathode (160) is electrically connected with the first region (1351) of the back contact layer, and an anode (170) is electrically connected with the second region (1352) of the back contact layer within each photovoltaic subunit.

## Description

The present invention relates to a thin film photovoltaic unit and a photoelectrochemical module comprising such a thin film photovoltaic unit. The present invention further relates to a method for forming such a photovoltaic unit, to a method for forming such a photoelectrochemical module and to a use of such a module.

### Prior art

Thin film photovoltaic cells and modules are widely known and are used for generating electrical power from impinging light. The thin film photovoltaic cells each comprise a front contact, a back contact and an absorber layer formed between the front contact and the back contact. At least the front contact is transparent for light of wavelengths the absorber layer is sensitive for. Usually, a plurality of such photovoltaic cells is electrically connected in series by electrically connecting the front contact of one photovoltaic cell with the back contact of a neighboring photovoltaic cell. Such a plurality of series-connected cells is also called a string.

In recent times, photovoltaic cells are used in integrated photoelectrochemical cells for providing electrical energy for generation of hydrogen by an electrolysis process of water. US 2008/0223439 A1 describes such a photoelectrochemical cell (PEC) and a PEC module (or PEC system) comprising a plurality of such PECs. For each PEC, a so called photoelectrode is formed which provides electrical energy for the electrolysis process in one photoelectrochemical cell. The photoelectrode comprises, for instance, a plurality of thin film photovoltaic cells, which are series-connected. Each photovoltaic cell is formed by a front electrode, a back electrode and an absorber layer formed between the front electrode and the back electrode. A metal back contact layer has, within one PEC, exactly one first region, which is electrically conductive connected to a front electrode of a first photovoltaic cell within the plurality of photovoltaic cells, and exactly one second region, which forms a back electrode of a last photovoltaic cell within the plurality of photovoltaic cells. The first region and the second region are electrically insulated from each other and from further back electrodes or front electrodes of other photovoltaic cells within the plurality of photovoltaic cells. The photoelectrode further comprises a first conducting layer electrically conductive connected to the first region of the metal back contact layer and a second conducting layer electrically conductive connected to the second region of the metal back contact layer, wherein the first conducting layer and the second conducting layer are electrically insulated from other regions of the metal back contact layer by an insulating layer. The first conducting layer is the anode of the PEC and the second conducting layer is the cathode of the PEC, or vice versa. Each PEC further comprises a reactor having a reduction compartment formed in contact with the cathode and an oxidation compartment formed in contact with the anode. The PEC module is formed by a plurality of such PECs lying side on side to each other, wherein layers forming the photovoltaic cells, i.e. a front electrode layer, the absorber layer and the metal back contact layer, are formed in common for all the PECs. Within the PEC module, cathodes and anodes for neighboring PECs are arranged alternatingly. Between neighboring reduction and oxidation compartments, a plastic shield with an ion conduction membrane is arranged.

The prior art modules and devices have at least one of the following shortcomings:
- It is difficult to provide enough electrical power for performing high efficiency electrolysis by the photoelectrode.
- The number of reduction and oxidation compartments is high and the costs for the ion conduction membranes cannot be decreased.
- The construction of the reactor strongly depends on the arrangement of photovoltaic cells in the photoelectrode.

### Object of the invention

The object is therefore to provide another composition of the PEC, in particular with respect to the photovoltaic unit of the PEC, and another composition of the PEC module, which both reduce at least some disadvantages of the state of the art. Another object is to provide a method for forming a photovoltaic unit for such a PEC and a method for forming a PEC module.

### Solution of the object

According to the invention, the task is solved by a photovoltaic unit, a photoelectrochemical module, a method for forming such a photovoltaic unit and a method for forming such a photoelectrochemical module according to the independent claims as well as the use of such a photoelectrochemical module. Advantageous embodiments of the invention are indicated in the dependent claims.

A first aspect of the invention provides a thin film photovoltaic unit comprising a transparent substrate, at least two photovoltaic cells, a front contact layer, which is arranged on the transparent substrate and forms front contacts of respective thin film photovoltaic cells, an absorber layer, which is arranged on the front contact layer and is configured to generate photovoltage under illumination, and a back contact layer, which is arranged on the absorber layer. The photovoltaic unit further comprises at least one cathode and at least one anode.

"A transparent substrate" means that the substrate is transparent for light of wavelengths the absorber layer is suitable for absorbing and generating photovoltage. Such a substrate may be, for instance, glass or a plastic, when the wavelengths being absorbed by the absorber layer lie in the range of 300 nm to 1.5 µm. The substrate is arranged at a light impinging side of the photovoltaic unit. If only "substrate" is mentioned in the following description, this means the transparent substrate.

The front contact layer may be, for instance, a layer of a transparent conductive material, e.g. a transparent conductive oxide (TCO) like indium tin oxide or others, or a layer stack comprising such a layer of a transparent conductive material and further layers, e.g. buffer layers. The front contact layer is arranged on the transparent substrate, wherein "on" here and hereafter with respect also to other layers or components does not mean that a direct contact between the mentioned two layers or components must be given. Instead, other layers may be arranged between the mentioned two layers or components.

The absorber layer may be made of any suitable material, e.g. comprising at least two of cadmium, selenium or tellurium. Nevertheless, also other materials may be used. Furthermore, the absorber layer may be a layer stack comprising layers of different materials, for instance a CdSeₓTe₁₋ₓ layer and a CdTe layer. In any case, the absorber layer or at least one layer of it may have a concentration gradient of one or more elements over its thickness or may be doped, wherein the doping concentration may vary over its thickness, or may be an intrinsic layer having an uniform composition, e.g. CdSeₓTe₁₋ₓ with 0.2 ≤ x ≤ 0.4 and x being constant over the thickness of the absorber layer or at least one layer of it.

The back contact layer may be made of a single layer of an electrically conductive material. Nevertheless, the back contact layer may be a layer stack comprising different layers, like for instance two or more of an Ohmic contact layer, e.g. of a metal chalcogenide like ZnTe or others, a metal nitride or metal oxynitride layer, e.g. MoN, MoON, TiN or TiON, or a metal layer, e.g. Al, Mo, Cr, Cu or Ti. The final layer, i.e. that layer of the back contact layer being furthermost from the absorber layer, may be one out of Mo, Ti, MoN, TiN, Cr. These materials may serve as a seed layer for the material of the cathode or the anode.

The front contact layer, the absorber layer and the back contact layer form a layer stack which is called photo layer in the following description.

The at least two photovoltaic cells are formed within the photo layer, wherein the front contact of each individual photovoltaic cell is formed by a region of the front contact layer, the absorber of each individual photovoltaic cell is formed by a region of the absorber layer, and the back contact of each individual photovoltaic cell is formed by a specific region of the back contact layer. The individual photovoltaic cells are divided by isolation trenches extending through at least one of the layers of the photo layer. The composition of the photovoltaic unit, in particular of the photovoltaic cells, is so far known from other photovoltaic devices.

The thin film photovoltaic unit is divided into a first photovoltaic subunit and a second photovoltaic subunit, each of which comprises one or more of the thin film photovoltaic cells. If the first and/or the second photovoltaic subunit comprises more than one photovoltaic cell, the photovoltaic cells of the respective subunit are series connected with each other.

In each photovoltaic subunit, the back contact layer comprises a first region that is electrically connected with the front contact of one of the thin film photovoltaic cells of the respective photovoltaic subunit, and a second region that serves as a back contact of one of the thin film photovoltaic cells of the respective photovoltaic subunit. If the first and/or the second subunit comprises only one photovoltaic cell, the first region is electrically connected with the front contact of the photovoltaic cell of the respective subunit and the second region serves as the back contact of the same photovoltaic cell. If the first and/or the second photovoltaic subunit comprises two or more photovoltaic cells, the first region is electrically connected with the front contact of a first one of the photovoltaic cells of the respective subunit and the second region serves as the back contact of another one of the photovoltaic cells of the respective subunit, in particular of the last one of the photovoltaic cells connected in series. That is, the photovoltaic cell(s) connected to the first region of the back contact layer and/or to the second region of the back contact layer may be one and the same or may be different photovoltaic cells.

The first photovoltaic subunit and the second photovoltaic subunit share a common first region of the back contact layer. That is, the first region of the back contact layer is electrically connected with the front contact of one of the thin film photovoltaic cells of the first photovoltaic subunit and with the front contact of one of the thin film photovoltaic cells of the second photovoltaic subunit. In other words: the first and the second photovoltaic subunit are arranged adjacent to the common first region.

Within each photovoltaic subunit, the at least one cathode is directly or indirectly electrically connected with the first region of the back contact layer, and the at least one anode is directly or indirectly electrically connected with the second region of the back contact layer. "Directly electrically connected" means that the two mentioned components or layers are in direct electrically conductive contact, whereas "indirectly electrically connected" means that an electrically insulating material forming a tunnel layer or an interlayer made of an electrically conductive material is arranged between the two mentioned components or layers. In any case, an electrically conductive connection is established, wherein the contact resistance between the cathode or anode and the respective first or second region of the back contact layer is lower than 300 µΩ.

In embodiments, the first photovoltaic subunit and the second photovoltaic subunit share a common cathode. That is, only one cathode is connected with the first region of the back contact layer.

In embodiments, the thin film photovoltaic unit further comprises a contact cell arranged between the first photovoltaic subunit and the second photovoltaic subunit. The contact cell is a region within the photo layer which does not contribute to generation of photovoltage, but serves only for establishing electrical contact between the first region of the back contact layer and the front contact of one of the photovoltaic cells of the first photovoltaic subunit and the front contact of one of the photovoltaic cells of the second photovoltaic subunit.

In embodiments, the width of the individual thin film photovoltaic cells within the first and/or the second photovoltaic subunit is equal or different. In some embodiments, all individual photovoltaic cells of a respective photovoltaic subunit have the same width.

In special embodiments, the ratio of a width of an individual thin film photovoltaic cell within the first and/or the second photovoltaic subunit to the width of the contact cell is greater than 0.5 and lower than 20, preferably greater than 1 and lower than 10, more preferably greater than 2 and lower than 3. In some embodiments, the individual photovoltaic cell of a respective photovoltaic subunit, the ratio of its width to the width of the contact cell is given, is a last photovoltaic cell of the photovoltaic cells connected in series in the respective subunit and is arranged furthest from the contact cell. In other words: The individual photovoltaic cell, for which the ratio of its width to the width of the contact cell is given, is that photovoltaic cell which has one of the second regions of the back contact layer as the back contact and is, therefore, electrically conductive connected to the anode.

In embodiments, the ratio of the area of one of the at least one anode to the area of one of the at least one cathode is greater than 0.5 and less than 20, preferably greater than 1 and less than 10, more preferably greater than 2 and less than 3.

In embodiments, wherein the at least one anode and the at least one cathode are arranged in a strip like manner, wherein stripes of the at least one anode and of the at least one cathode are separated from each other by an isolating strip with a width of at least 2 mm. The isolating strip electrically insulates the individual stripes of the at least one anode and of the at least one cathode. The isolating strip may be formed, for instance, of an insulating material like an electrically insulating resist or any other dielectric.

In embodiments, one or more third regions are arranged in the back contact layer, which are separated from the first region and the second region by an insulation material. That is, all regions in the back contact layer not being one of the first regions or one of the second regions and lying between the first region and the second region of one photovoltaic subunit are third regions. At least one third region exists, if a respective subunit comprises two or more photovoltaic cells. In other words: The third regions are the back contacts of that photovoltaic cells of a respective subunit which are not the last photovoltaic cell of the respective subunit and which are not electrically conductively connected to an anode or a cathode. The first, second and third regions in the back contact layer and the insulation material are arranged in the same plane of the thin film photovoltaic unit, i.e. in the plane of the back contact layer.

In special embodiments, an insulation layer is arranged on the respective third regions, on which at least one part of the at least one anode and/or at least one part of the at least one cathode is arranged. This insulation layer guaranties that the at least one anode and/or the at least one cathode does not have an electrically conductive contact to the back contact layer of that photovoltaic cells, the back contacts of which are formed by the third regions. Further, in special embodiments, a conductive layer can be partly formed between the anode or cathode and the insulation layer. That is, the conductive layer may be formed between the anode or the cathode and the insulation layer in the whole area in which the anode or the cathode overlaps the insulation layer or only in parts of that area. In further embodiments, the conductive layer is formed not only on the insulation layer, i.e. above the third regions(s), but also on the first and/or the second region(s) of the back contact layer. In other words, at the end, the conductive layer may be formed beneath a part of or the whole area of the cathode and/or the anode. The conductive layer provides the possibility for forming the cathode and/or the anode by electroplating in a simple manner. The described conductive layer may be provided on the first and/or second regions of the back contact layer independently from whether an insulation layer is formed on the respective third regions of the back contact layer.

In embodiments, the anode and the cathode are arranged in a T-shape manner, wherein first parts of the T-shape of respective anode and cathode are interlocked with each other, and wherein second parts of the T-shape of the respective anode and cathode are not interlocked, arranged on both sides of the thin film photovoltaic unit, and formed outside or inside the range of the thin film photovoltaic unit.

A second aspect of the invention provides a photoelectrochemical module. The photoelectrochemical module comprises at least one thin film photovoltaic unit according to the present invention and at least one electrochemical reactor. Each electrochemical reactor covers at least one cathode and at least one anode respectively of one of the at least one thin film photovoltaic unit. Further, for each reactor, at least one oxidation compartment and at least one reduction compartment are formed accordingly. That is, each electrochemical reactor comprises at least one oxidation compartment and one reduction compartment, wherein the at least one anode covered by the electrochemical reactor lies within one of the at least one oxidation compartment and the least one cathode covered by the electrochemical reactor lies within one of the at least one reduction compartment.

In embodiments, the at least one oxidation compartment and the at least one reduction compartment are separated by an ion conduction membrane. If the electrochemical reactor comprises more than one reduction compartment and/or more than one oxidation compartment, each reduction compartment is separated from an adjacent oxidation compartment by an ion conduction membrane and vice versa.

In embodiments, one electrochemical reactor covers at least one thin film photovoltaic unit. That is, the electrochemical reactor has at least one reduction compartment and at least two oxidation compartments.

The photoelectrochemical module according to the invention may provide a plurality of advantages. First of all, the number of ion conduction membrans, which are cost-intensive, can be reduced, since only one reduction compartment is necessary per photovoltaic unit, wherein the reduction compartment comprises the cathodes of the first and the second photovoltaic subunit connected to the common first region of the back contact layer. Furthermore, if two or more photovoltaic units are present, further ion conduction membrans or separation shields can be saved, since the anodes of adjacent photovoltaic units are formed directly adjacent to each other - only separated by an insulating mate. rial - and, therefore, separation shields between two adjacent oxidation compartments may be saved. Moreover, the arrangement of the anodes and the cathodes and the respective oxidation or reduction compartments may be designed more independently from the arrangement of the photovoltaic cells than in prior art.

A third aspect of the invention provides a method for forming a thin film photovoltaic unit, which may be used for forming a thin film photovoltaic unit according to the invention. The method comprises a sequence of steps which may be performed in different orders as long as this order is logical. In embodiments, the method steps are performed in the order given here. Nevertheless and in any case, further method steps, for instance cleaning steps, may be performed at any place within the method, for instance between some of the steps explained in the following. With respect to materials or features of the arrangement of layers or components, the explanations given above are valid.

In a first step of the method, a layer stack is provided which comprises a transparent substrate and a front contact layer. The front contact layer is arranged on the transparent substrate and is configured to form front contacts of respective thin film photovoltaic cells. The layer stack may be bought from a supplier or may be formed within the method.

The method further comprises a second step comprising a substep of applying an absorber layer on the front contact layer and a substep of performing a first scribing step for generating first scribe lines. The substeps of this step may be performed in the given order, i.e. first applying the absorber layer and then performing the first scribing step, or may be performed in the reverse order, i.e. first performing the first scribing step and then applying the absorber layer. In the result of the first order, the first scribe lines cut through the front contact layer and the absorber layer. Alternatively, the first scribe lines cut only through the front contact layer. In performing the first order of substeps, this step is followed by a step of filling the first scribe lines with an insulating material, whereas, in performing the second order of substeps, the first scribe lines in the front contact layer are filled with the material of the absorber layer.

In any case, a third step of the method comprises performing a second scribing step for generating second scribe lines. The second scribe lines cut through the absorber layer and are different from the first scribe lines. In embodiments, the second scribe lines extend in parallel to the first scribe lines. The third step may be performed simultaneously or quasi-simultaneously with the substep of scribing the first scribe lines in the second step, when the respective substep is performed after applying the absorber layer. Simultaneously means that the first scribe lines and the second scribe lines are formed at the same time, for instance using two scribe devices, e.g. two laser-scribe devices. Quasi-simultaneously means that the first scribe lines and the second scribe lines are formed alternatingly, for instance using one and the same scribe device, e.g. one and the same laser-scribe device.

In a fourth step of the method, a back contact layer is deposited on the absorber layer, thereby filling the second scribe lines with the material of the back contact layer. In some embodiments the back contact layer is a layer stack comprising different layers of different materials. In some embodiments, one or more, but not all, of the layers of the back contact layer may be deposited before performing the second scribing step.or before performing the first and the second scribing step. The last case may be present, if the first scribing step is performed after applying the absorber layer. In any case, at least one layer of the back contact layer is deposited after performing the second scribing step.

Thereafter, a third scribing step for generating third scribe lines is performed in a fifth step of the method. The third scribe lines cut at least through the back contact layer, thereby forming different regions of the back contact layer which are separated from each other. In particular, at least one first region of the back contact layer and at least two second regions of the back contact layer are formed. The third scribe lines may also cut through the absorber layer. In any case, the third scribe lines are different from the first scribe lines and the second scribe lines. In embodiments, the third scribe lines extend in parallel to the first scribe lines and/or the second scribe lines. In the result, at least two thin film photovoltaic cells are formed, each having a front contact formed by a region of the front contact layer, an absorber formed by a region of the absorber layer and a back contact formed by a region of the back contact layer. Each thin film photovoltaic cell is separated from a neighboring photovoltaic cell by at least one first scribe line and one second scribe line or by at least one second scribe line and one third scribe line. The first region of the back contact layer is electrically connected with the front contacts of two of the thin film photovoltaic cells, and the second regions of the back contact layer serve as back contacts of two of the thin film photovoltaic cells.

In a sixth step of the method, an isolation scribing step for generating isolation scribe lines is performed, wherein the fifth step and the sixth step may be performed simultaneously or quasi simultaneously similar as explained above with respect to the first and second scribe lines. The isolation scribe lines cut through the back contact layer, the absorber layer and the front contact layer. In any case, the isolation scribe lines are different from the first scribe lines and the second scribe lines, but may be formed instead of individual third scribe lines. In embodiments, the isolation scribe lines extend in parallel to the first scribe lines and/or the second scribe lines and/or the third scribe lines. In the end of the method, the isolation scribe lines separate a formed thin film photovoltaic unit from other thin film photovoltaic units or from other components adjacent to it.

In a seventh step of the method, the third scribe lines and the isolation scribe lines are filled with an insulation material.

In an eighth step of the method, at least one cathode is provided directly or indirectly on the first region of the back contact layer, and at least one anode is provided directly or indirectly on the second regions of the back contact layer. This step may comprise applying a layer of a material of the cathode and of the anode on the back contact layer and performing a structuring process in order to provide the at least one cathode and the at least one anode. This may be done if the material of the cathode and of the anode is the same. Nevertheless, it is also possible to apply a layer of a material of the cathode and a layer of a material of the anode separately. In the result of this step, the at least one cathode is electrically conductively connected to the first region of the back contact layer and the at least one anode is electrically conductively connected to the second region of the back contact layer. Furthermore, the eighth step of the method may also comprise applying one or more layers made of electrically conductive materials between the first and/or second regions of the back contact layer and the at least one cathode and/or the at least one anode. In some embodiments, a layer made of an electrically conductive material is provided on the first and/or the second regions of the back contact layer and serves as a seed material for applying the cathode and/or anode by electroplating.

In embodiments, the method is performed such that a first photovoltaic subunit and a second photovoltaic subunit are formed in the thin film photovoltaic unit, wherein each of the photovoltaic subunits comprises one or more thin film photovoltaic cells that are series connected with each other. That is, if the first photovoltaic subunit and/or the second photovoltaic subunit comprises more than one thin film photovoltaic cells, the photovoltaic cells of the respective photovoltaic subunit are connected in series with each other. In embodiments, one first region of the back contact layer is formed within the area of the thin film photovoltaic unit, wherein the first region is electrically connected with the front contact of one photovoltaic cell of each photovoltaic subunit.

In special embodiments, a common cathode is formed between the first photovoltaic subunit and the second photovoltaic subunit. That is, the common cathode is shared between the first and the second photovoltaic subunits.

In embodiments, a contact cell is formed between the first photovoltaic subunit and the second photovoltaic subunit.

In embodiments, the width of the individual thin film photovoltaic cells within the first and/or the second photovoltaic subunit is equal or different. The width of one individual thin film photovoltaic cell is defined by the distance of a first scribe line to a third scribe line, wherein no second scribe line is formed between the respective first scribe line and the respective third scribe line.

In embodiments, within the first and/or the second photovoltaic subunit, the ratio of a width of an individual thin film photovoltaic cell to the width of the contact cell is greater than 0.5 and lower than 20, preferably greater than 1 and lower than 10, more preferably greater than 2 and lower than 3. In some embodiments, the individual photovoltaic cell of a respective photovoltaic subunit, the ratio of its width to the width of the contact cell is given, is a last photovoltaic cell of the photovoltaic cells connected in series in the respective subunit and is arranged furthest from the contact cell.

In embodiments, the ratio of the area of one of the at least one anode to the area of one of the at least one cathode is greater than 0.5 and less than 20, preferably greater than 1 and less than 10, more preferably greate r than 2 and less than 3.

In embodiments, one or more third regions are formed in the back contact layer during the step of performing a third scribing step. The at least one third region is separated from the first and the second region(s) by third scribe lines and the insulation material formed within the third scribe lines in the seventh step of the method. If a plurality of third regions is formed and two or more third regions are formed neighboring to each other, the respective third regions are separated from each other also by third scribe lines and the insulation material formed within the third scribe lines in the seventh step.

In special embodiments, the method further comprises a step in which an insulation layer is formed at least partially on the third region(s). In embodiments, this step is performed before providing at least one cathode on the first region of the back contact layer and at least one anode on the second region(s) of the back contact layer. Thus, the cathode and/or the anode may be formed partially on the third region(s), wherein the cathode and/or the anode is electrically separated or insulated from the third region(s) by the insulation layer. Of course, the cathode and the anode are separated from each other. In other embodiments, this step is performed after providing at least one cathode on the first region of the back contact layer and at least one anode on the second region(s) of the back contact layer. Thus, the insulation layer is formed in between the cathode and the anode in order to improve the electrical insulation of the cathode and the anode from each other. In further embodiments, this step may be performed twice, once before providing at least one cathode on the first region of the back contact layer and at least one anode on the second region(s) of the back contact layer, and once after providing at least one cathode on the first region of the back contact layer and at least one anode on the second region(s) of the back contact layer. In this case, a first insulation layer is formed on which a part of the cathode and/or a part of the anode may be formed, and a second insulation layer is formed between the cathode and the anode.

In embodiments, in which an insulation layer is formed at least partially on the third region(s), the method further comprises a step in which a conductive layer is formed at least partially on the insulation layer. In special embodiments, this step is performed before providing at least one cathode on the first region of the back contact layer and at least one anode on the second region(s) of the back contact layer. The conductive layer is formed such that, at the end, the conductive layer is formed only between the cathode and/or the anode and the insulation layer. That is, the conductive layer may be formed only partially beneath that part of the cathode and/or the anode being arranged above the insulation layer or the conductive layer may be formed beneath the whole part of the cathode and/or the anode being arranged above the insulation layer. In further embodiments, the conductive layer is formed not only on the insulation layer, i.e. above the third regions(s), but also on the first and/or the second region(s) of the back contact layer. In other words, at the end, the conductive layer may be formed beneath a part of or the whole area of the cathode and/or the anode.

A fourth aspect of the invention provides a method for forming a photoelectrochemical module, wherein the method comprises forming at least one of thin film photovoltaic units through the above described method and forming at least one electrochemical reactor. Each electrochemical reactor covers at least one cathode and at least one anode respectively, wherein for each reactor, at least one oxidation compartment and at least one reduction compartment are formed accordingly. With respect to materials or features of the arrangement of layers or components, in particular with respect to the electrochemical reactor, the explanations given above are valid.

A fifth aspect of the invention refers to a use of a photoelectrochemical module according the invention for generation of hydrogen and/or oxygen.

The invention is not limited to the embodiments shown and described, but also includes all embodiments having the same effect within the meaning of the invention. Furthermore, the invention is also not limited to the specifically described combinations of features, but may also be defined by any other combination of specific features of all the individual features disclosed as a whole, provided that the individual features are not mutually exclusive, or a specific combination of individual features is not explicitly excluded.

### Exemplary embodiments

The following detailed description of exemplary embodiments of the invention is presented to enable any person skilled in the art to make and use the disclosed subject matter in the context of one or more particular implementations. Various modifications to the disclosed implementations will be readily apparent to those skilled in the art, and the general principles defined herein may be applied to other implementations and applications without departing from scope of the disclosure. Thus, the present disclosure is not intended to be limited to the described or illustrated implementations, but is to be accorded the widest scope consistent with the principles and features disclosed herein.

Implementations of the invention will be described, by way of example only, with reference to accompanying drawings in which:
- **Fig. 1A**: shows a first embodiment of the thin film photovoltaic unit according to the invention in a cross-sectional view.
- **Fig. 1B**: shows a second embodiment of the thin film photovoltaic unit according to the invention in a cross-sectional view.
- **Fig. 1C**: shows a third embodiment of the thin film photovoltaic unit according to the invention in a cross-sectional view.
- **Fig. 1D**: shows an equivalent circuit diagram of the thin film photovoltaic unit according to the invention.
- **Fig. 1E**: shows a plan view on specific components of the thin film photovoltaic unit according to the invention for explaining some dimensions.
- **Fig. 2A**: shows a first part of a first embodiment of the photoelectrochemical module according to the invention in a cross-sectional view.
- **Fig. 2B**: shows a plan view on the first part of the first embodiment of the photoelectrochemical module shown in Fig. 2A.
- **Fig. 2C**: shows a plan view on a larger part of the first embodiment of the photoelectrochemical module.
- **Fig. 3A**: shows a second embodiment of the photoelectrochemical module according to the invention in a cross-sectional view.
- **Fig. 3B**: shows a plan view on the second embodiment of the photoelectrochemical module.
- **Fig. 4A**: shows a plan view on a third embodiment of the photoelectrochemical module according to the invention.
- **Fig. 4B**: shows a plan view on a fourth embodiment of the photoelectrochemical module according to the invention.
- **Fig. 5**: shows a first embodiment of a method for forming a photoelectrochemical module according to the invention.

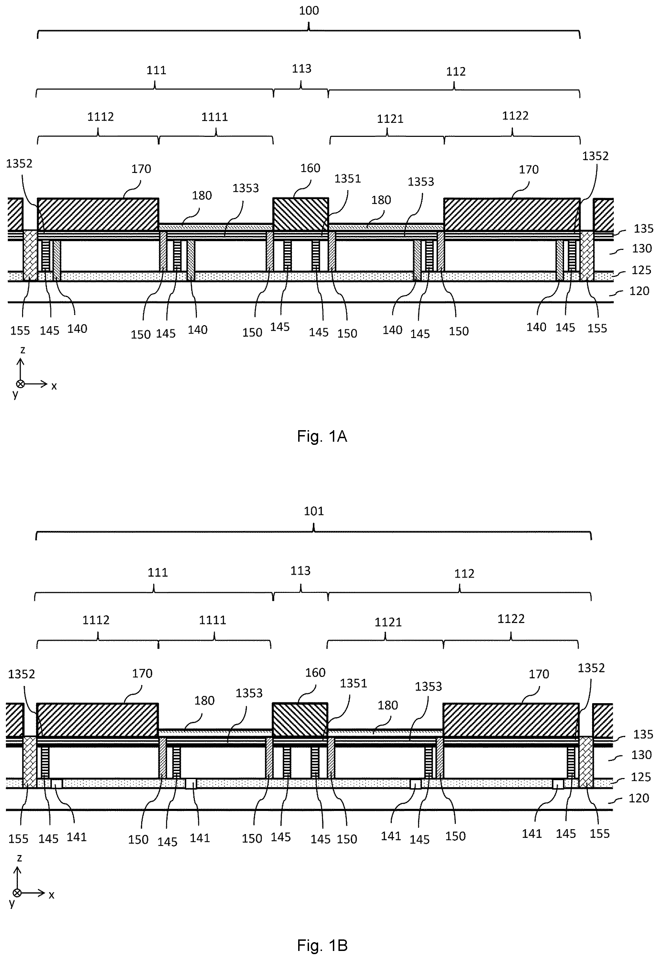

**Figure 1A** shows a first embodiment 100 of the thin film photovoltaic unit according to the invention in a cross-sectional view, i.e. in a x-z plane of a three-dimensional cartesian coordinate system. The photovoltaic unit 100 comprises a first photovoltaic subunit 111, a second photovoltaic subunit 112 and a contact cell 113 between the first photovoltaic subunit 111 and the second photovoltaic subunit 112. Each of the first and the second photovoltaic subunit 111, 112 comprises a plurality of photovoltaic cells which are connected in series within the respective photovoltaic subunit 111 and 112. In the embodiment shown, the first photovoltaic subunit 111 comprises two photovoltaic cells 1111 and 1112, and the second photovoltaic subunit 112 comprises two photovoltaic cells 1121 and 1122. In other embodiments, the number of photovoltaic cells within one photovoltaic subunit may vary from 1 to 10, and is preferably 2 or 3.

The photovoltaic cells serve for generating electrical energy by generating electron-hole pairs due to illumination, whereas the contact cell 113 does not contribute. Each photovoltaic submodule 111, 112 may provide a minimum voltage of 1.23 V.

The photovoltaic cells 1111, 1112, 1121, 1122 and the contact cell 113 are formed in layer stack comprising a transparent substrate 120, a front contact layer 125, an absorber layer 130 and a back contact layer 135. In order to separate the individual photovoltaic cells 1111, 1112, 1121 and 1122 as well as the contact cell 113 from each other, first scribe lines 140 and third scribe lines 150 are formed, which are filled with an electrically insulating material. The first scribe lines 140 extend through the front contact layer 125 and the absorber layer 130, and the third scribe lines 150 extend through the absorber layer 130 and the back contact layer 135. Second scribe lines 145 extending through the absorber layer 130 and being filled with an electrically conductive material, for instance one of the at least one material of the back contact layer 135, provides an electrically conductive connection of a back contact of one photovoltaic cell, e.g. 1111, to a front contact of an adjacent photovoltaic cell of the same photovoltaic subunit, e.g. 1112 of the first photovoltaic subunit 111, thereby forming a series connection of these photovoltaic cells. Furthermore, some second scribe lines 145 form an electrically conductive connection of the contact cell 113, in particular of the back contact of the contact cell 113, to the front contacts of the adjacent photovoltaic cells, e.g. 1111 and 1121. The photovoltaic unit 100 is separated from other components, for instance from adjacent photovoltaic units, by an isolation scribe line 155 filled with an electrically insulating material. The electrically insulating materials filling the first scribe lines 140, the third scribe lines 150 and the isolation scribe lines 155 may be the same or may be different. For instance, the insulating material may be an insulating resist, an insulating varnish, or any resistive material like, e.g., silicon oxide or aluminum oxide.

The third scribe lines 150 and the isolation scribe lines 155 divide the back contact layer 135 into different regions: a first region 1351 arranged within the contact cell 113, two second regions 1352 forming the back contacts of the photovoltaic cells 1112 and 1122, and two third regions 1353 forming the back contacts of the photovoltaic cells 1111 and 1121. The first region 1351 is electrically conductively connected with the front contacts of first photovoltaic cells of the respective photovoltaic subunit 111 and 112, i.e. with the front contacts of the photovoltaic cells 1111 and 1121. The first photovoltaic cell is that photovoltaic cell which is arranged nearest to the contact cell 113. The second regions 1352 are formed in any case as the back contacts of the last photovoltaic cells in the respective photovoltaic subunit 111 and 112. The last photovoltaic cell is that photovoltaic cell which is arranged furthermost from the contact cell 113. If more than two photovoltaic cells are formed within one or both photovoltaic subunits 111 or 112, the back contacts of all photovoltaic cells not being the last ones within the respective photovoltaic subunit form third regions 1353 of the back contact layer 135. That is, in this case, more than two third regions 1353 are formed within the back contact layer 135. Although in the shown embodiment only one first region 1351 is formed, also two first regions may be formed each of which is electrically conductively connected with the photovoltaic cell 1111 or with the photovoltaic cell 1121. Furthermore, the number of first, second and third regions 1351, 1352 and 1353 is not limited to two or by the number of photovoltaic cells, however each region 1351, 1352 and 1353 is assigned to only one photovoltaic cell.

The photovoltaic unit 100 further comprises a cathode 160 and two anodes 170. The cathode 160 is formed within the region of the contact cell 113 and is electrically conductively connected with the first region 1351. The anodes 170 are formed within the regions of the last photovoltaic cells of the photovoltaic subunits 111 and 112, i.e. of the photovoltaic cells 1112 and 1122. The anodes 170 are electrically conductively connected with the second regions 1352. In the shown embodiment, the cathode 160 and the anodes 170 are formed directly on the back contact layer 135. The cathode 160 and the anodes 170 may be formed of the same material or of different materials, wherein these materials are known from the state of the art. For instance, such a material is platin or a platin containing material, in particular for the cathode, or ruthenium oxide or iridium oxide, in particular for the anode, or compositions thereof.

The cathode 160 and the anodes 170 are electrically separated from each other and from the third regions 1353 of the back contact layer 135 by an insulating layer 180 made of an electrically insulating material, for instance a high resistive oxide like aluminum oxide or an insulating varnish.

**Fig. 1B** shows a second embodiment 101 of the thin film photovoltaic unit according to the invention in a cross-sectional view. The thin film photovoltaic unit 101 differs from the first embodiment 100 only in design of the first scribe lines. The photovoltaic unit 101 comprises first scribe lines 141 which extend only through the front contact layer 125 and which are filled with the material of the absorber layer 130.

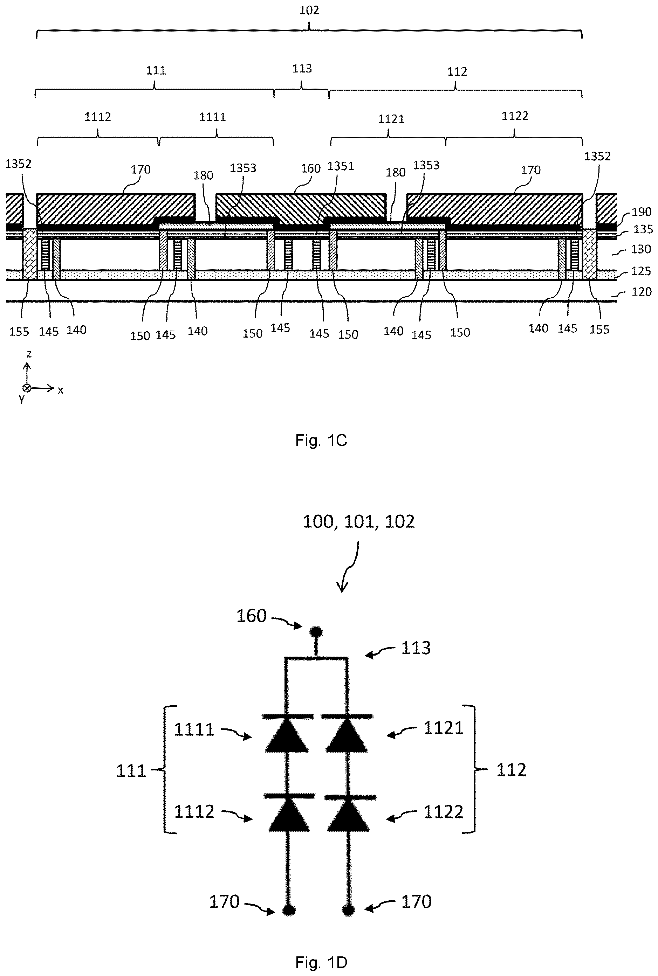

**Fig. 1C** shows a third embodiment 102 of the thin film photovoltaic unit according to the invention in a cross-sectional view. The thin film photovoltaic unit 102 differs from the first embodiment 100 in the design of the cathode 160 and the anodes 170. In this embodiment, the area of the cathode 160 and the anodes 170 is increased, since the cathode 160 and the anodes 170 each overlap the third regions 1353 of the back contact layer 135. That is, a part of the cathode 160 and a part of each anode 170 is arranged over the third regions 1353, wherein that parts of the cathode 160 or the anodes 170 are electrically insulated from the third regions 1353 by the insulation layer 180. Furthermore, a conductive layer 190 is formed between the cathode 160 and the anodes 170 and the underlying layers, i.e. the back contact layer 135 or the insulating layer 180, respectively. The conductive layer 190 is made of an electrically conductive material, for instance a metal layer, which served as a seed layer in an electroplating process for applying the cathode 160 and/or the anodes 170 or which may serve for improving the electrical contact between the cathode 160 and/or the anode 170 and the first and/or second regions of the back contact layer 135, respectively, or for other purposes like a diffusion barrier. Nevertheless, the conductive layer 190 may be omitted or may also be present in the first and second embodiments 100 and 101 of the photovoltaic unit. In any case, the cathode 160 and the anodes 170 are separated and electrically insulated from each other.

In the shown embodiments, the first and the second photovoltaic subunits 111 and 112 share a common first region 1351 of the back contact layer 135 and a common cathode 160. Nevertheless, a plurality of first regions of the back contact layer may be present, wherein each first region may be electrically conductively connected with one cathode. In other word, a plurality of cathodes may be present, wherein each cathode is electrically conductively connected with at least one first region of the back contact layer. The same is true for the second regions of the back contact layer and for the anodes. As will be explained later, the two anodes 170 shown in the present embodiments may even be electrically conductively connected with each other, thereby forming only one anode, i.e. a common anode.

As shown, the arrangement and size of the cathode 160 and the anode(s) 170 with respect to the photovoltaic cells 1111, 1112, 1121 and 1122 can be adopted to the demands of the photovoltaic unit and of a photoelectrochemical module, in which the photovoltaic unit is used for providing electrical energy.

According to the invention, the photovoltaic unit 100 to 102 comprises two photovoltaic subunits, wherein the photovoltaic cells of each subunit are connected in series and wherein the photovoltaic subunits are connected in parallel. This is illustrated in **Fig. 1D** showing an equivalent circuit diagram of the thin film photovoltaic unit 100 to 102 according to the invention. The photovoltaic cells 1111 and 1112 of the first photovoltaic subunit 111 are connected in series, and the photovoltaic cells 1121 and 1122 of the second photovoltaic subunit 112 are connected in series. The first and second photovoltaic subunits 111 and 112 are connected in parallel by the contact cell 113 and are electrically conductively connected via the contact cell 113 to the cathode 160. The last photovoltaic cells 1112 and 1122 of the first and the second photovoltaic subunits 111 and 112 are electrically conductively connected with the anodes 170.

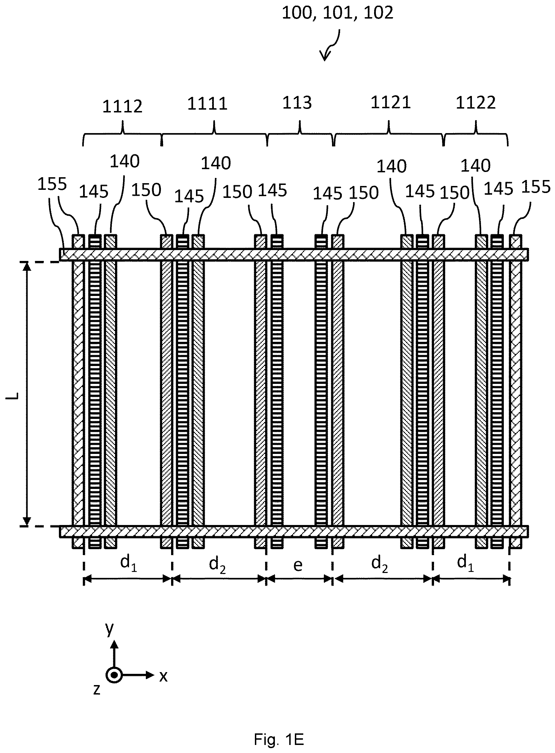

**Fig. 1E** shows a plan view on specific components of the thin film photovoltaic unit 100 to 102 according to the invention for explaining some dimensions. Here, only the photovoltaic cells 1111, 1112, 1121 and 1122 as well as the contact cell 113 are shown. Furthermore, the first, second and third scribe lines 140, 145 and 150 as well as the isolation scribe lines 155 are shown. In the plan view, it is further seen that the photovoltaic module 100 to 102 is separated from other components, e.g. further photovoltaic modules, by the isolation scribe lines 155 not only along the x-direction, but also along the y-direction. The distance between two isolation scribe lines 155 along the y-direction defines a length L of the photovoltaic cells 1111, 1112, 1121 and 1122 and of the whole photovoltaic unit 100 to 102. The length L may lie in the range of 1 cm to 240 cm, in particular of 5 cm to 80 cm. The photovoltaic cells 1111, 1112, 1121 and 1122 may have the same width or different widths. As shown in Fig. 1E, the photovoltaic cells being arranged on the same position within the first or the second photovoltaic subunit 111 and 112 may have the same width which may differ from the width of other photovoltaic cells within the same photovoltaic subunit. For instance, the last photovoltaic cells within the photovoltaic subunits, i.e. the photovoltaic cells 1112 and 1122, have a first width d₁, whereas the first photovoltaic cells within the photovoltaic subunits, i.e. the photovoltaic cells 1111 and 1121, have a second width d₂ with d₁ = d₂ or d₁ ≠ d₂. Furthermore, the contact cell 113 has a width e. The widths d₁ and d₂ may lie in the range of 1 mm to 20 mm, and the ratio of d₁ to e may be 0.5 ≤ d₁/e ≤ 20. Preferably, this ratio lies in the range of 1 to 10 and more preferably in the range of 2 to 3. In the first and the second embodiment 100 and 101 of the photovoltaic unit shown in Figs. 1A and 1B, this ratio defines the ratio of the area of one anode to the area of the cathode. All widths are measured along the x-direction.

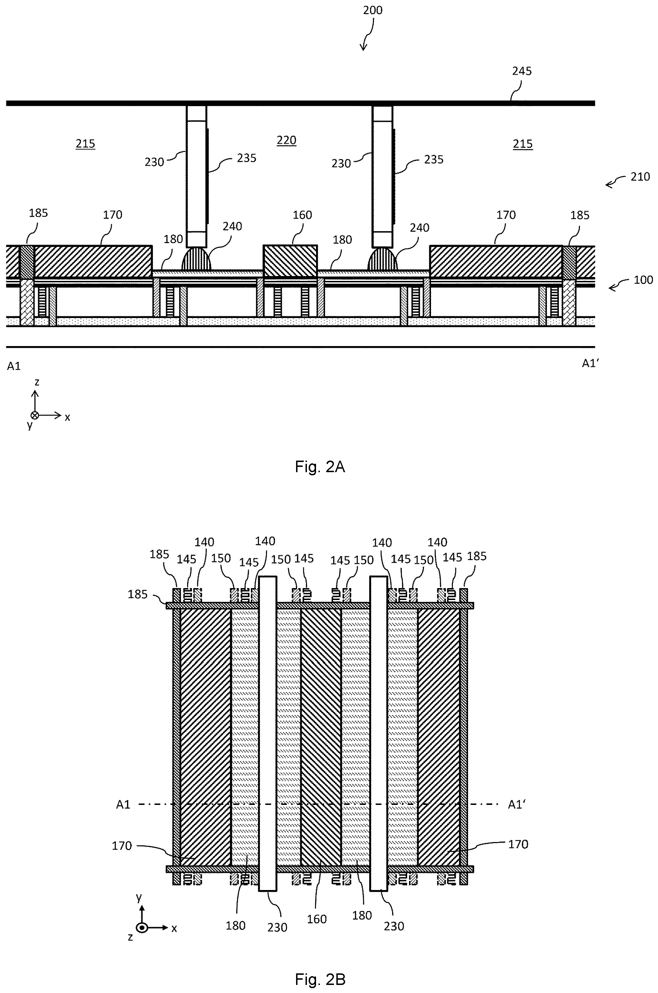

**Figure 2A** shows a first part of a first embodiment 200 of the photoelectrochemical module according to the invention in a cross-sectional view, whereas **Fig. 2B** shows a plan view on the first part of the first embodiment 200. The line A1-A1' in Fig. 2B indicates the intersection which cross-sectional view is shown in Fig. 2A. The photoelectrochemical module 200 comprises the photovoltaic unit 100 as described above and an electrochemical reactor 210. Furthermore, the photoelectrochemical module 200 comprises an isolation strip 185 formed between the anodes 170 of the photovoltaic unit 100 and adjacent components of the photoelectrochemical module 200 as will be described later. The isolation strip 185 is made of an electrically insulating material, e.g. of an insulating varnish.

The electrochemical reactor 210 comprises at least one oxidation compartment 215 (in the shown embodiment two oxidation compartments 215) and at least one reduction compartment 220. The oxidation compartments 215 and the reduction compartment 220 are separated from each other by shield 230 having openings, e.g. holes, and an ion conduction membrane 235 on one surface of each shield, wherein the ion conduction membrane 235 covers the openings. The shields 230 and the ion conduction membrane 235 serve for the conduction of protons, separation of product gases, and electrical insulation of the oxidation compartments 215 and the reduction compartment 220. The shields 230 are arranged between the cathode 160 and the respective anodes 170. They are arranged on the insulation layer 180 by supports 240, which may be made of an electrically insulating material, e.g. a resist, a varnish or an insulator like silicon oxide or aluminum oxide. The electrochemical reactor 210 is separated from an environment by a housing 245. Fig. 2A does not show an inlet for water or other feed materials, e.g. an electrolyte, into the oxidation compartments 215 and/or into the reduction compartment 220, and does not show an outlet for gases, e.g. hydrogen or oxygen, out of the reduction compartment 220 and/or the oxidation compartments 215. Such inlets and outlets may be arranged at any position of the electrochemical reactor 210 and are known to a person skilled in the art as are in principle all components of the electrochemical reactor 210.

**Fig. 2B** shows the arrangement of the cathode 160, the anodes 170 and the shields 230 in a plan view in order to explain a layout of the electrochemical reactor 210. Further shown are the first, second and third scribing lines 140, 145 and 150, which, however, do not lie on the surface of the photovoltaic unit 100. Therefore, they are shown only with dashed lines. Fig. 2B further shows the isolations strips 185. As can be seen, the shields 130 extend parallel to each other and are arranged between the cathode 160 and a respective one of the anodes 170 on the insulating layer 180. The cathode 160 and the anodes 170 are formed as stripes extending parallel to each other.

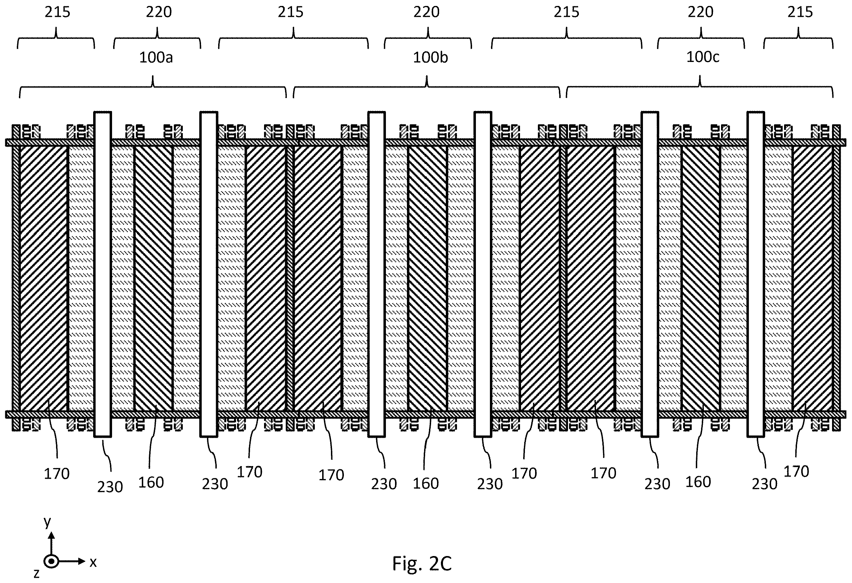

**Fig. 2C** shows a plan view on a larger part of the first embodiment 200 of the photoelectrochemical module. Preferably, the photoelectrochemical module 200 comprises not only one photovoltaic unit 100 as shown in Fig. 2A, but at least two photovoltaic units arranged adjacent to each other.

The number of photovoltaic units is not limited and may lie in the range of 1 to 100, for instance in the range of 1 to 10 or in the range of 40 to 60 or in the range of 70 to 100 or in any other subrange. The number of photovoltaic units may be adapted to the intended output of hydrogen and/or oxygen and/or to other conditions, like the area being available. In Fig. 2C, three photovoltaic units 100a to 100c are shown lying side by side. Thus, one anode 170 of the photovoltaic unit 100a lies adjacent to one anode 170 of the photovoltaic unit 100b, whereas the second anode 170 of the photovoltaic unit 100b lies adjacent to one anode 170 of the photovoltaic unit 100c. In each case, adjacent anodes of different photovoltaic units 100a to 100c are separated from each other by the isolation strip 185, but are assigned to one and the same oxidation compartment 215. Thus, some shield 230 and ion conduction membranes 235 may be saved as compared to prior art as described in US 2008/0223439 A1.

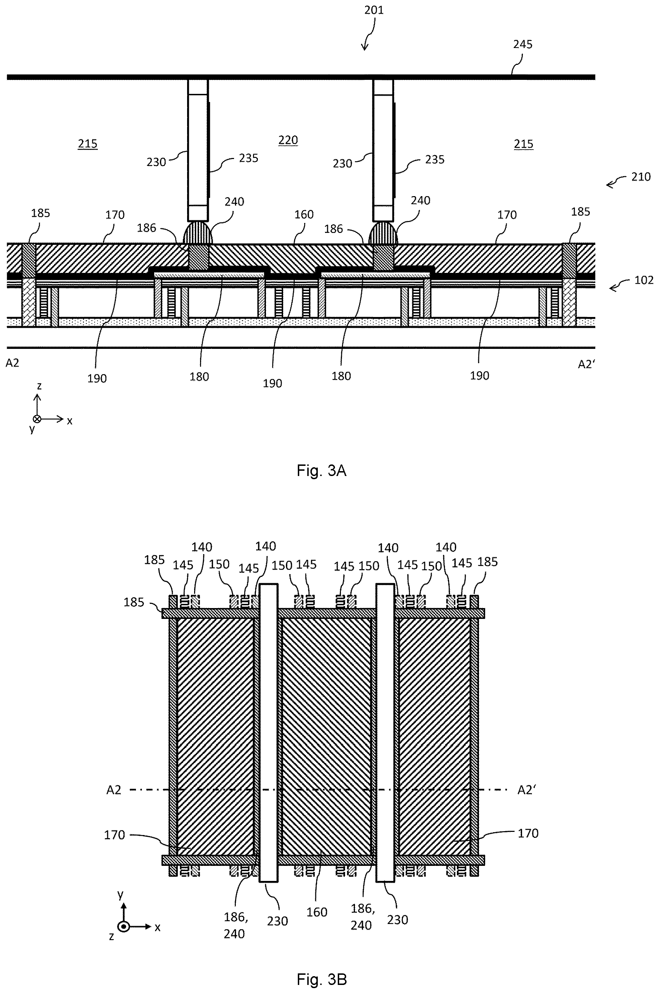

**Figure 3A** shows a second embodiment 201 of the photoelectrochemical module according to the invention in a cross-sectional view, whereas **Fig. 3B** shows a plan view on it. The line A2-A2' in Fig. 3B indicates the intersection which cross-sectional view is shown in Fig. 3A. The photoelectrochemical module 201 differs from the first embodiment 200 in that it comprises the photovoltaic unit 102, i.e. the third embodiment of the photovoltaic unit, instead the first embodiment of the photovoltaic unit. Therefore, the design of the cathode 160 and the anodes 170 is different. In this embodiment, the area of the cathode 160 and the anodes 170 is increased, since the cathode 160 and the anodes 170 each overlap the third regions of the back contact layer as described with respect to Fig. 1C. The shield 230 are now arranged directly above isolation strips 186 arranged between the anodes 170 and the cathode 160. The isolation strips 186 may be formed of the same material as the isolation strips 185 or of another material. The isolation strips 185 have a width measured along the x-direction in the range of 30 µm to 1 mm, preferably around 100 µm.

As can be seen in Fig. 3B, the cathode 160 and the anodes 170 are formed again as stripes, wherein the areas of the cathode 160 and the anodes 170 are increased with respect to the first embodiment 200, thereby improving the oxidation or reduction reactions within the oxidation or reduction compartments 215, 220.

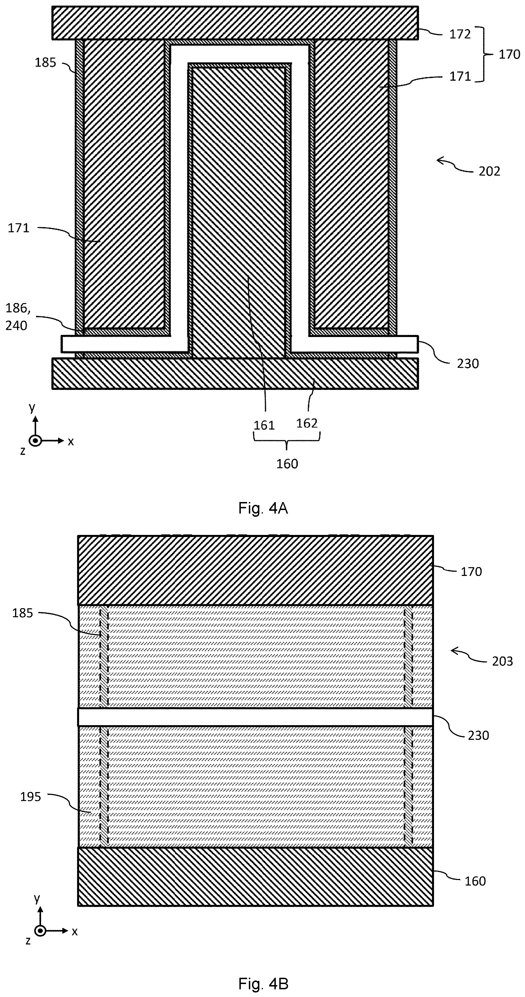

With respect to Figs. 4A and 4B, two further embodiments of the photoelectrochemical module according to the invention and, in particular, two further layouts of the cathode 160 and the anodes 170 and the shields 230 will be explained. **Figure 4A** shows a third embodiment and **Fig. 4B** shows a fourth embodiment of the photoelectrochemical module, in each case in plan views thereon.

The third embodiment 202 shown in **Fig. 4A** differs from the second embodiment 201 in that the cathode 160 and the anode 170 are arranged in a T-shape manner in the plan view. That is, the cathode 160 has a first part 161 and a second part 162, and the anode 170 also has a first part 171 and a second part 172. The first parts 161 and 171 of the cathode 160 and the anode 170, respectively, extend along the y-direction, whereas the second parts 162 and 172 of the cathode 160 and the anode 170, respectively, extend along the x-direction. It has to be noted, that the cathode 160 may comprise a plurality of first parts 161 and the anode 170 may comprise a plurality of first parts 171, if a plurality of photovoltaic units are provided adjacent to each other. The first parts 161 of the cathode 160 are connected with each other by the second part 162, and the first parts 171 of the anode 170 are connected with each other by the second part 172. That is, the cathode 160 and the anode 170 are formed as combs, wherein the teeth of the combs, i.e. the first parts 161 and 171, are interlocked with each other and are arranged parallel to each other. The second parts 162 and 172 are not interlocked with each other, but are also arranged parallel to each other. The second parts 162 and 172 are arranged on opposite sides of the photovoltaic unit with respect to the y-direction, wherein they may be formed outside or inside the range of the photovoltaic unit. The cathode 160 and the anode 170 are again separated from each other by the isolation strip 186 as described with respect to Fig. 3A and 3B. Furthermore, the shield 230 follows the contour of the cathode 160 and the anode 170, thereby separating one common oxidation compartment and one common reduction compartment from each other. That is, the number of shields and ion conduction membranes can be further reduced, wherein however the layout of the shield is more complicated as compared to the first and second embodiments 200 and 201.

In the fourth embodiment 203 of the photoelectrochemical module shown in **Fig. 4B****,** the cathode 160 and the anode 170 each is formed only by a strip of the cathode material or the anode material, each strip extending along the x-direction. The underlying construction may be formed as shown in Fig. 4A, whereas, however, the combs may be formed of a material different from the materials of the cathode 160 and the anode 170. For instance, the combs as shown in Fig. 4A may be formed only by the conductive layer 190 shown in Fig. 3A. The second parts of the combs are then electrically conductively connected with the cathode 160 or the anode 170, respectively, wherein the dimensions of the cathode 160 and the anode 170 may be chosen more freely. Furthermore, the arrangement of the cathode 160 and the anode 170 with respect to the second parts of the combs is relatively free as long as the electrically conductive connection is given. Thus, the cathode 160 and the anode 170 may also extend along the y-direction or along a direction oblique to the x- and the y-direction. In any case, the cathode 160 and the anode 170 may extend parallel to each other. Further, in any case, the cathode 160 and the anode 170 are separated from each other and from underlying components to which they are not electrically conductively connected by a further insulation layer 195. The insulation layer 195 may be made of any suitable electrically insulating material, for instance of insulating varnish or silicon oxide or aluminum oxide. The shield 230 is arranged between the cathode 160 and the anode 170 and may extend parallel to them. This embodiment provides the largest freedom with respect to the layout of the cathode 160, the anode 170 and the shield 230 and the possibility for saving costs.

Nevertheless, other embodiments and layouts as described with respect to Figs. 2A to 4B may be designed. The present invention provides a large freedom of layout and a high possibility of saving costs.

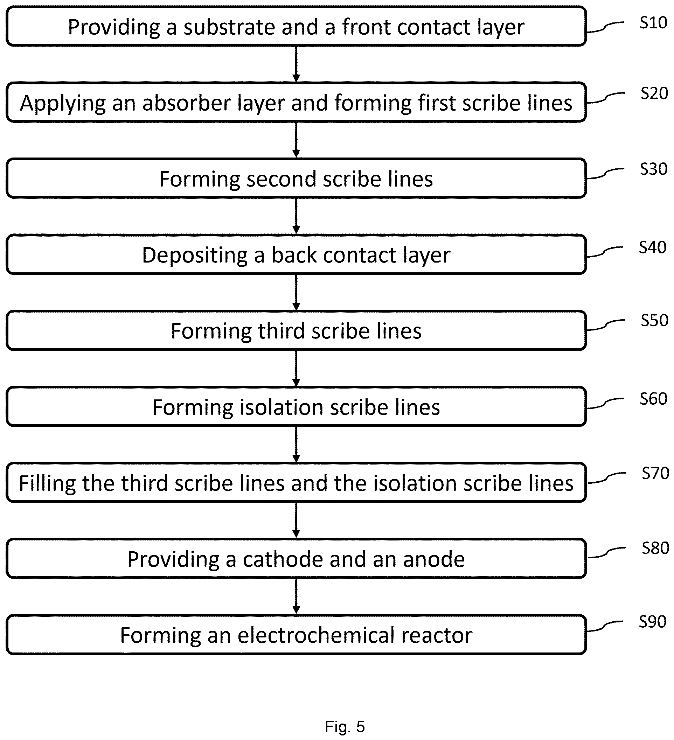

**Figure 5** shows a first embodiment of a method for forming a photoelectrochemical module according to the invention. This method includes a first embodiment of a method for forming a thin film photovoltaic unit according to the invention (steps S10 to S80). That is, thin film photovoltaic cells are formed during the method.

In a first step S10, a layer stack comprising a transparent substrate and a front contact layer is provided. The front contact layer is arranged on the transparent substrate and is configured to form front contacts of respective thin film photovoltaic cells.

In a second step S20, an absorber layer is applied on the front contact layer and a first scribing step for generating first scribe lines is performed. The Absorber layer may be applied by any method known from the state of the art, e.g. by evaporation or close-space sublimation (CSS). The absorber layer may comprise any material suitable for absorbing light and generating photovoltage, wherein the absorber layer may comprise only one material or may comprise layers of different materials. Furthermore, a further treatment of the absorber layer material, e.g. an activation, may be comprised in this step. The first scribe lines may be formed before or after applying the absorber layer. If the first scribe lines are formed after applying the absorber layer, they cut through the front contact layer and the absorber layer. Furthermore, a step of filling the first scribe lines with an insulating material, i.e. an electrically insulating material, is performed after forming the first scribe lines in that case. If the first scribe lines are formed before applying the absorber layer, they cut through the front contact layer. In this case, the first scribe lines are filled with the material of the absorber layer by applying the absorber layer on the front contact layer.

In a third step S30, second scribe lines are generated in a second scribing step. The second scribe lines cut through the absorber layer.

In a fourth step S40, a back contact layer is deposited on top of the absorber layer. The back contact layer may be a layer stack of layers made of different materials as described above. By depositing the back contact layer, the second scribe lines are filled with the material of at least one layer of the back contact layer.

In a fifth step S50, a third scribing step for generating third scribe lines is performed. The third scribe lines cut through at least the back contact layer, thereby forming a first region of the back contact layer that is electrically connected with the front contacts of two of the thin film photovoltaic cells and two second regions of the back contact layer that serve as back contacts of two of the thin film photovoltaic cells. In embodiments, the third scribe lines may cut also through the absorber layer, but not through the front contact layer.

In a sixth step S60, an isolation scribing step for generating isolation scribe lines is performed. The isolation scribe lines cut through the back contact layer, the absorber layer, and the front contact layer.

All scribing steps may be performed by methods known from the prior art, e.g. by laser scribing, wherein all scribing steps may be performed in the same way or by using different methods. Some of the scribing steps may be performed simultaneously or quasi-simultaneously, i.e. in one and the same apparatus without an interfering step. For instance, the first scribing step and the second scribing step may be performed simultaneously or quasi-simultaneously, if the first scribing step is performed after applying the absorber layer. In further embodiments, the third scribing step and the isolation scribing step may be performed simultaneously or quasi-simultaneously.

In a seventh step S70, the third scribe lines and the isolation scribe lines are filled with an insulation material, i.e. an electrically insulating material.

The filling of the first scribe lines in step S20, if performed at all, and step S70 may be performed using any method known from the state of the art, for instance printing an insulating ink into the respective scribe lines or applying a resist or any other insulating material as a layer and structuring it afterwards. Filling the respective scribe lines with an insulating material may be done in the same way or by using different methods. Furthermore, the insulating material may be the same or different for the individual scribe lines.

In an eighth step S80, at least one cathode is directly or indirectly provided on the first region of the back contact layer, and at least one anode is directly or indirectly provided on the second regions of the back contact layer. The cathode and the anode may be provided using any method known from prior art, e.g. by depositing by physical vapour deposition (e.g. sputtering or evaporation) a layer of a material of the cathode and/or the anode and structuring this layer afterwards or by selectively applying a layer of a material of the cathode and/or the anode on the respective regions of the back contact layer, e.g. by electroplating. The cathode and/or the anode may also comprise two or more layers of different materials, which may be formed by different methods. Furthermore, the cathode and the anode may be formed of the same materials or different materials and may be formed by the same or different method.

Further steps for forming one or more insulation layers or for forming a conductive layer may be performed, for instance before performing step S80, wherein both steps may include structuring of the respective layer.

In the result of steps S10 to S80, a photovoltaic unit is formed comprising a plurality of photovoltaic cells and a cathode and an anode. Due to the arrangement of the first to third scribe lines, some photovoltaic cells may be connected in series, wherein others may be connected in parallel. By choosing the size of the cathode and/or anode, their arrangement and the presence and thickness of further layers, e.g. insulating layers or conductive layers, as well as the materials of all the mentioned layers, the electric output of the photovoltaic cells may be transported to the anode and/or cathode without loss and the efficiency of the whole photoelectrochemical module may be increased.

In a further step S90, at least one electrochemical reactor is formed, wherein each electrochemical reactor covers at least one cathode and at least one anode respectively, wherein for each reactor, at least one oxidation compartment and at least one reduction compartment are formed accordingly. That is, the at least one electrochemical reactor is formed such that it covers the photovoltaic unit and provides at least one oxidation compartment and at least one reduction compartment by providing a shield separating each oxidation compartment from an adjacent reduction compartment and vice versa. The methods for forming such an electrochemical reactor are in principle known from the state of the art. The present invention, however, provides the possibility to choose the size of the cathode and the anode independent from the size of the individual photovoltaic cells. Thus, the efficiency of hydrogen production may be increased. Furthermore, the arrangement of the cathode and the anode as well as a shield between the oxidation compartment and the reduction compartment can be simplified and more freely chosen as in the state of the art, as described with respect to Figs. 3A to 4B. Thus, the requirements to the reactor are reduced with respect to prior art. Further, the safety of hydrogen production may be increased.

Although not explicitly mentioned here, further steps or intermediate steps, like cleaning steps or steps for treating a surface of any of the layers provided, applied or deposited in the method, may be comprised by the method according to the invention.

If the description uses the wording "photovoltaic unit", this means "thin film photovoltaic unit". The same is true for "photovoltaic cells" instead of "thin film photovoltaic cells".

### List of reference signs

- 100, 101, 102, 100a - 100c: Thin film photovoltaic unit
- 111: First photovoltaic subunit
- 112: Second photovoltaic subunit
- 1111, 1112, 1121, 1122: Photovoltaic cell
- 113: Contact cell
- 120: Substrate
- 125: Front contact layer
- 130: Absorber layer
- 135: Back contact layer
- 1351: First region of the back contact layer
- 1352: Second region of the back contact layer
- 1353: Third region of the back contact layer
- 140, 141: First scribe line
- 145: Second scribe line
- 150: Third scribe line
- 155: Isolation scribe line
- 160: Cathode
- 161: First part of the cathode
- 162: Second part of the cathode
- 170: Anode
- 171: First part of the anode
- 172: Second part of the anode
- 180: Insulation layer
- 185, 186: Isolation strip
- 190: Conductive layer
- 195: Further insulation layer
- 200 - 203: Photoelectrochemical module
- 210: Electrochemical reactor
- 215: Oxidation compartment
- 220: Reduction compartment
- 230: shield
- 235: Ion conduction membrane
- 240: Support
- 245: Housing

- d₁, d₂: Width of a photovoltaic cell
- e: Width of the contact cell
- L: Length of a photovoltaic unit

## Claims

1. A thin film photovoltaic unit comprising
- a transparent substrate,
- at least two photovoltaic cells,
- a front contact layer, which is arranged on the transparent substrate and forms front contacts of respective thin film photovoltaic cells,
- an absorber layer, which is arranged on the front contact layer and is configured to generate photovoltage under illumination, and
- a back contact layer, which is arranged on the absorber layer,
wherein the thin film photovoltaic unit is divided into a first photovoltaic subunit and a second photovoltaic subunit, each of which comprises one or more of the thin film photovoltaic cells that are series connected with each other,
wherein, in each photovoltaic subunit, the back contact layer comprises a first region that is electrically connected with the front contact of one of the thin film photovoltaic cells of the respective photovoltaic subunit, and a second region that serves as a back contact of one of the thin film photovoltaic cells of the respective photovoltaic subunit,
wherein the first photovoltaic subunit and the second photovoltaic subunit share a common first region of the back contact layer,
wherein, within each photovoltaic subunit, at least one cathode is directly or indirectly electrically connected with the first region of the back contact layer, and at least one anode is directly or indirectly electrically connected with the second region of the back contact layer.

2. The thin film photovoltaic unit according to claim 1, wherein the first photovoltaic subunit and the second photovoltaic subunit share a common cathode.

3. The thin film photovoltaic unit according to claim 1 or 2, wherein the thin film photovoltaic unit further comprises a contact cell arranged between the first photovoltaic subunit and the second photovoltaic subunit.

4. The thin film photovoltaic unit according to any of the claims 1 to 3, wherein the width of the individual thin film photovoltaic cells within the first and/or the second photovoltaic subunit is equal or different.

5. The thin film photovoltaic unit according to any of the claims 3 or 4, wherein, within the first and/or the second photovoltaic subunit, the ratio of a width of a last thin film photovoltaic cell to the width of the contact cell is greater than 0.5 and lower than 20, preferably greater than 1 and lower than 10, more preferably greater than 2 and lower than 3.

6. The thin film photovoltaic unit according to any of the claims 1 to 5, wherein the ratio of an area of one of the at least one anode to an area of one of the at least one cathode is greater than 0.5 and less than 20, preferably greater than 1 and less than 10, more preferably greater than 2 and less than 3.

7. The thin film photovoltaic unit according to any of the claims 1 to 6, wherein the at least one anode and the at least one cathode are arranged in a strip like manner, wherein stripes of the at least one anode and of the at least one cathode are separated from each other by an isolating strip with a width of at least 2 mm.

8. The thin film photovoltaic unit according to any of the claims 1 to 7, wherein one or more third regions are arranged in the back contact layer, which are separated from the first and the second region by an insulation material.

9. The thin film photovoltaic unit according to claim 8, wherein an insulation layer is arranged on the respective third regions, on which at least one part of the at least one anode and/or at least one part of the at least one cathode is arranged.

10. The thin film photovoltaic unit according to any of the claims 1 to 9, wherein the anode and the cathode are arranged in a T-shape manner, wherein first parts of the T-shape of the respective anode and cathode are interlocked with each other, and wherein second parts of the T-shape of the respective anode and cathode are not interlocked, arranged on both sides of the thin film photovoltaic unit, and formed outside or inside the range of the thin film photovoltaic unit.

11. A photoelectrochemical module, comprising at least one thin film photovoltaic unit according to any one of claims 1 to 10, and at least one electrochemical reactor, wherein each electrochemical reactor covers at least one cathode and at least one anode respectively, wherein, for each reactor, at least one oxidation compartment and at least one reduction compartment are formed accordingly.

12. The photoelectrochemical module according to claim 11, wherein the at least one oxidation compartment and the at least one reduction compartment are separated by an ion conduction membrane.

13. The photoelectrochemical module according to claim 11 or 12, wherein one electrochemical reactor covers at least one thin film photovoltaic unit.

14. A method for forming a thin film photovoltaic unit, comprising the following steps:
1) Providing a layer stack comprising:
- a transparent substrate,
- a front contact layer, which is arranged on the transparent substrate and is configured to form front contacts of respective thin film photovoltaic cells,
2) Applying an absorber layer on the front contact layer and performing a first scribing step for generating first scribe lines, through which the front contact layer and the absorber layer are cut through, followed by a step of filling the first scribe lines with an insulating material; or alternatively, performing a first scribing step for generating first scribe lines, through which the front contact layer is cut through, followed by applying an absorber layer on the front contact layer, through which the cut in the front contact layer is filled with the absorber materials,
3) Performing a second scribing step for generating second scribe lines, through which the absorber layer is cut through,
4) Depositing a back contact layer, thereby filling the second scribe lines with the material of the back contact layer,
5) Performing a third scribing step for generating third scribe lines, through which the back contact layer is cut through, thereby forming a first region of the back contact layer that is electrically connected with the front contacts of two of the thin film photovoltaic cells and two second regions of the back contact layer that serve as back contacts of two of the thin film photovoltaic cells,
6) Performing an isolation scribing step for generating isolation scribe lines, through which the back contact layer, the absorber layer and the front contact layer are cut through,
7) Filling the third scribe lines and the isolation scribe lines with an insulation material,
8) Providing at least one cathode directly or indirectly on the first region of the back contact layer, and at least one anode directly or indirectly on the second regions of the back contact layer.

15. The method according to claim 14, wherein a first photovoltaic subunit and a second photovoltaic subunit are formed in the thin film photovoltaic unit, each of which comprises one or more thin film photovoltaic cells that are series connected with each other.

16. The method according to claim 15, wherein a common cathode is formed between the first photovoltaic subunit and the second photovoltaic subunit.

17. The method according to 15 or 16, wherein a contact cell is formed between the first photovoltaic subunit and the second photovoltaic subunit.

18. The method according to any of the claims 15 to 17, wherein the width of the individual thin film photovoltaic cells within the first and/or the second photovoltaic subunit is equal or different.

19. The method according to any of the claims 15 to 18, wherein, within the first and/or the second photovoltaic subunit, the ratio of a width of a last thin film photovoltaic cell to the width of the contact cell is greater than 0.5 and lower than 20, preferably greater than 1 and lower than 10, more preferably greater than 2 and lower than 3.

20. The method according to any of the claims 15 to 19, wherein the ratio of the area of one of the at least one anode to the area of one of the at least one cathode is greater than 0.5 and less than 20, preferably greater than 1 and less than 10, more preferably greater than 2 and less than 3.

21. The method according to any of the claims 15 to 20, wherein one or more third regions are formed in the back contact layer, which are separated from the first and the second region by the insulation material formed in step 7).

22. The method according to 21, wherein an insulation layer is formed at least partially on the third region.

23. The method according to claim 22, wherein a conductive layer is formed at least partially on the insulation layer.

24. A method for forming a photoelectrochemical module at least comprising the following steps:
i. Forming at least one of thin film photovoltaic units through the method according to any of claims 14 to 23,
ii. Forming at least one electrochemical reactor, wherein each electrochemical reactor covers at least one cathode and at least one anode respectively, wherein for each reactor, at least one oxidation compartment and at least one reduction compartment are formed accordingly.

25. Use of a photoelectrochemical module according to any of claims 11 to 13 for generation of hydrogen and/or oxygen.
